# EUROPEAN PATENT APPLICATION

(11) **EP 4 579 737 A1**
(43) Date of publication of application: **02.07.2025**
(21) Application number: 23859025.1
(22) Date of filing: 31.07.2023
(51) Int. Cl.: H01L 23/498

(54) **SEMICONDUCTOR POWER MODULE, MOTOR CONTROLLER, AND VEHICLE**

(30) Priority: 31.08.2022 CN 202211058483
(71) Applicant: BYD Company Limited, Shenzhen, Guangdong 518118 (CN)
(72) Inventor: LIU, Chunjiang, Shenzhen, Guangdong 518118 (CN); ZHANG, Chong, Shenzhen, Guangdong 518118 (CN); ZHANG, Jianli, Shenzhen, Guangdong 518118 (CN)
(74) Representative: Taor, Simon Edward William
(86) International application number: PCT/CN2023/110386
(87) International publication number: WO 2024/045990

(57) **Abstract**

A vehicle (1000), comprising a motor controller (2). The motor controller comprises a semiconductor power module (1). The semiconductor power module comprises a substrate (100), a first conductive region (110), a second conductive region (120), at least one first power chip (200), and at least one second power chip (300). The substrate has a first direction and a second direction orthogonal to each other, and the first conductive region and the second conductive region are spaced apart on the substrate. The first conductive region comprises a first transverse section (111) and a second transverse section (112), the second conductive region comprises a third transverse section (121) and a fourth transverse section (122), and the first transverse section, the third transverse section, the second transverse section, and the fourth transverse section are sequentially arranged in a first direction. The first conductive region and the second conductive region are used for transmitting direct current signals. The first power chip is respectively connected to the first transverse section and the third transverse section, and the second power chip is respectively connected to the second transverse section and the fourth transverse section.

## Description

### CROSS-REFERENCE TO RELATED APPLICATIONS

The present disclosure claims priority to and benefits of Chinese Patent Application No. 202211058483.1, filed on August 31, 2022 and entitled "SEMICONDUCTOR POWER MODULE, MOTOR CONTROLLER, AND VEHICLE". The entire content of the above-referenced application is incorporated herein by reference.

### FIELD

The present disclosure relates to the field of semiconductor technologies, and in particular, to a semiconductor power module, a motor controller, and a vehicle.

### BACKGROUND

Semiconductor power modules are widely used in industry. The semiconductor power module is usually used in an inverter to convert an alternating current into a direct current, or convert a direct current into an alternating current. The semiconductor power module has advantages such as high integration and a small volume. However, in an inversion process, a voltage generated by a stray inductance of a loop during switching of a semiconductor chip is excessively large, and electromagnetic interference is generated due to damped oscillation, which increases a switching loss. In addition, if a high current is to be output, multiple chips need to be connected in parallel, and thus a region occupied by the chips is large, and an inductance is also increased accordingly.

### SUMMARY

The present disclosure aims to resolve at least one of the technical problems in the prior art. Therefore, an objective of the present disclosure is to provide a semiconductor power module. The semiconductor power module has advantages such as a small stray inductance and a good heat dissipation effect.

The present disclosure further provides a motor controller having the foregoing semiconductor power module.

The present disclosure further provides a vehicle having the foregoing motor controller.

To achieve the foregoing objective, a first aspect of an embodiment according to the present disclosure provides a semiconductor power module, including: a substrate, the substrate having a first direction and a second direction orthogonal to each other; a first conductive region and a second conductive region that are spaced apart on the substrate, the first conductive region including a first transverse section and a second transverse section, the second conductive region including a third transverse section and a fourth transverse section, and the first transverse section, the third transverse section, the second transverse section, and the fourth transverse section being sequentially arranged in the first direction, where the first conductive region and the second conductive region are configured to transmit DC signals; and at least one first power chip and at least one second power chip, the first power chip being respectively connected to the first transverse section and the third transverse section, and the second power chip being respectively connected to the second transverse section and the fourth transverse section.

The semiconductor power module according to this embodiment of the present disclosure has advantages such as a small stray inductance and a good heat dissipation effect.

According to some embodiments of the present disclosure, the first conductive region further includes a first vertical section, the first transverse section and the second transverse section both extend in the second direction, the first vertical section extends in the first direction, and two ends of the first vertical section are respectively connected to the first transverse section and the second transverse section. The second conductive region further includes a second vertical section, the third transverse section and the fourth transverse section both extend in the second direction, the second vertical section extends in the first direction, and two ends of the second vertical section are respectively connected to the third transverse section and the fourth transverse section. The first vertical section and the second vertical section are respectively arranged adjacent to two opposite sides of the substrate in the second direction.

According to some embodiments of the present disclosure, an end of the first vertical section is flush with the second transverse section, a back side of the first transverse section, and the other end of the first vertical section is flush with the first transverse section, a back side of the second transverse section; and one end of the second vertical section is flush with the fourth transverse section, a back side of the third transverse section, and the other end of the second vertical section is flush with the third transverse section, a back side of the fourth transverse section.

According to some embodiments of the present disclosure, a side of the first vertical section that faces away from the second vertical section is flush with an end of the fourth transverse section away from the second vertical section; and a side of the second vertical section that faces away from the first vertical section is flush with a side of the first transverse section away from the first vertical section.

According to some embodiments of the present disclosure, the first power chip is mounted on the third transverse section, and the first power chip is connected to the first transverse section through a first connection member.

According to some embodiments of the present disclosure, the second power chip is mounted on the fourth transverse section, and the second power chip is connected to the second transverse section through a second connection member.

According to some embodiments of the present disclosure, the semiconductor power module includes: a third conductive region. The third conductive region is arranged on the substrate and spaced apart from the first conductive region and the second conductive region, and the third conductive region is constructed in a closed loop shape arranged around the first conductive region and the second conductive region.

According to some embodiments of the present disclosure, the third conductive region includes a third vertical section, a fourth vertical section, a fifth transverse section, and a sixth transverse section. The third vertical section and the fourth vertical section extend in the first direction and are spaced apart in the second direction; the fifth transverse section and the sixth transverse section extend in the second direction and are spaced apart in the first direction; the third vertical section, the fifth transverse section, the fourth vertical section, and the sixth transverse section are sequentially connected end to end; and the first conductive region and the second conductive region are located between the third vertical section and the fourth vertical section in the second direction; the fifth transverse section is located on the side of the fourth transverse section that faces away from the third transverse section in the first direction, where the third conductive region is configured to transmit DC signals. The semiconductor power module includes: at least one third power chip and at least one fourth power chip. The third power chip is arranged on the fifth transverse section, the third power chip is connected to the fourth transverse section, the fourth power chip is arranged on the fifth transverse section, and the fourth power chip is connected to the fourth transverse section.

According to some embodiments of the present disclosure, multiple third power chips are included, the multiple third power chips are spaced apart in the second direction, and the multiple third power chips are arranged in a row in the second direction. Multiple fourth power chips are included, the multiple fourth power chips are spaced apart in the second direction, and the multiple fourth power chips are arranged in a row in the second direction. The row in which the third power chips are located and the row in which the fourth power chips are located are spaced apart in the first direction. A sum of a quantity of first power chips and a quantity of second power chips is equal to a sum of a quantity of the third power chips and a quantity of the fourth power chips.

According to some embodiments of the present disclosure, the multiple third power chips and the multiple fourth power chips are alternately arranged in the second direction.

According to some embodiments of the present disclosure, the semiconductor power module includes: a fourth conductive region. The fourth conductive region is arranged on the substrate and is spaced apart from the first conductive region, the second conductive region, and the third conductive region. The fourth conductive region extends in the second direction and is located on a side of the fifth transverse section that faces away from the fourth transverse section, and the third power chip and the fourth power chip are both connected to the fourth conductive region. The fourth conductive region is configured to transmit AC signals.

According to some embodiments of the present disclosure, the third power chip is connected to the fourth transverse section through a third connection member, and the third power chip is connected to the fourth conductive region through a fourth connection member.

According to some embodiments of the present disclosure, the third connection member and the fourth connection member are constructed as an integrated member extending in the first direction.

According to some embodiments of the present disclosure, the fourth connection member and the fourth power chip are spaced apart in the second direction.

According to some embodiments of the present disclosure, the fourth power chip is connected to the fourth transverse section through a fifth connection member; and the fourth power chip is connected to the fourth conductive region through a sixth connection member.

According to some embodiments of the present disclosure, the fifth connection member and the sixth connection member are constructed as an integrated member extending in the first direction.

According to some embodiments of the present disclosure, the fifth connection member and the third power chip are spaced apart in the second direction.

According to some embodiments of the present disclosure, the semiconductor power module includes: a first DC transmission terminal, the first DC transmission terminal being connected to the first transverse section and extending beyond an edge of the substrate; a second DC transmission terminal, the second DC transmission terminal being connected to an end of the third vertical section away from the fifth transverse section and extending beyond the edge of the substrate; a third DC transmission terminal, the third DC transmission terminal being connected to an end of the fourth vertical section away from the fifth transverse section and extending beyond the edge of the substrate; and an AC transmission terminal, the AC transmission terminal being connected to the fourth conductive region and extending beyond the edge of the substrate.

According to some embodiments of the present disclosure, a low-voltage connection part is arranged on the side of the first transverse section that faces away from the second transverse section, a length of the low-voltage connection part is less than a length of the first transverse section and greater than a width of the first DC transmission terminal, and the first DC transmission terminal is connected to the low-voltage connection part.

According to some embodiments of the present disclosure, a first high-voltage connection part is arranged on the end of the third vertical section away from the fifth transverse section, a size of the first high-voltage connection part in the second direction is greater than a width of the third vertical section and greater than a width of the second DC transmission terminal, and the second DC transmission terminal is connected to the first high-voltage connection part. A second high-voltage connection part is arranged on the end of the fourth vertical section away from the fifth transverse section, a size of the second high-voltage connection part in the second direction is greater than a width of the fourth vertical section and greater than a width of the third DC transmission terminal, and the third DC transmission terminal is connected to the second high-voltage connection part.

According to some embodiments of the present disclosure, the substrate includes: an insulation layer; a circuit layer, the circuit layer being connected to a side of the insulation layer in a thickness direction, and the first conductive region and the second conductive region being formed on the circuit layer; and a heat dissipation layer, the heat dissipation layer being connected to another side of the insulation layer in the thickness direction.

According to some embodiments of the present disclosure, the semiconductor power module includes: an insulation cover. The insulation cover is mounted on the substrate and covers the first conductive region, the second conductive region, the first power chip, and the second power chip.

According to a second aspect of an embodiment of the present disclosure, a motor controller is provided, including: a heat dissipation bottom plate and a coolant channel, the heat dissipation bottom plate being mounted in the coolant channel; and the semiconductor power module according to the first aspect of the embodiment of the present disclosure, the semiconductor power module being arranged on the heat dissipation bottom plate.

According to the second aspect of the embodiment of the present disclosure, by using the semiconductor power module according to the first aspect of the embodiment of the present disclosure, the motor controller has advantages such as a small stray inductance and a good heat dissipation effect.

According to some embodiments of the present disclosure, multiple semiconductor power modules are arranged on the heat dissipation bottom plate in the second direction.

According to a third aspect of an embodiment of the present disclosure, a vehicle is provided, including: a motor; and the motor controller according to the second aspect of the embodiment of the present disclosure, the motor controller being connected to the motor.

According to the third aspect of the embodiment of the present disclosure, by using the motor controller according to the second aspect of the embodiment of the present disclosure, the vehicle has advantages such as a small stray inductance and a good heat dissipation effect.

Additional aspects and advantages of the disclosure will be given in the following descriptions, some of which will become apparent from the following descriptions or may be learned from practices of the disclosure.

### BRIEF DESCRIPTION OF THE DRAWINGS

The foregoing and/or additional aspects and advantages of the disclosure will become apparent and comprehensible in the description of the embodiments made with reference to the following accompanying drawings.
FIG. 1 is a schematic structural diagram of a semiconductor power module according to an embodiment of the present disclosure;
FIG. 2 is a schematic structural diagram of a semiconductor power module according to another embodiment of the present disclosure;
FIG. 3 is a schematic structural diagram of a semiconductor power module according to still another embodiment of the present disclosure;
FIG. 4 is a schematic diagram of a connection of a substrate, a first DC transmission terminal, a second DC transmission terminal, a third DC transmission terminal, and an AC transmission terminal according to an embodiment of the present disclosure;
FIG. 5 is a schematic diagram of a connection of a substrate, a first DC transmission terminal, a second DC transmission terminal, a third DC transmission terminal, and an AC transmission terminal from another perspective according to an embodiment of the present disclosure;
FIG. 6 is a schematic diagram of a circuit of a semiconductor power module according to an embodiment of the present disclosure;
FIG. 7 is a schematic diagram of a connection of a substrate, a third DC transmission terminal, and an AC transmission terminal according to an embodiment of the present disclosure;
FIG. 8 is a schematic structural diagram of a substrate according to an embodiment of the present disclosure;
FIG. 9 is a partial sectional view of a motor controller according to an embodiment of the present disclosure;
FIG. 10 is a partial schematic structural diagram of a motor controller according to an embodiment of the present disclosure; and
FIG. 11 is a schematic block diagram of a vehicle according to an embodiment of the present disclosure.

In the drawings:
Semiconductor power module 1, motor controller 2,
substrate 100, insulation layer 101, circuit layer 102, heat dissipation layer 103, heat dissipation bottom plate 104,
first conductive region 110, first transverse section 111, second transverse section 112, first vertical section 113,
second conductive region 120, third transverse section 121, fourth transverse section 122, second vertical section 123,
third conductive region 130, third vertical section 131, fourth vertical section 132, fifth transverse section 133, sixth transverse section 134,
fourth conductive region 140,
first power chip 200, first connection member 210,
second power chip 300, second connection member 310,
third power chip 400, third connection member 410, fourth connection member 420,
fourth power chip 500, fifth connection member 510, sixth connection member 520,
first DC transmission terminal 600, low-voltage connection part 610,
second DC transmission terminal 700, first high-voltage connection part 710,
third DC transmission terminal 800, second high-voltage connection part 810,
AC transmission terminal 900, vehicle 1000, motor 1001; insulation cover 1100, coolant channel 1200, where
a first direction is a direction indicated by an arrow A, and a second direction is a direction indicated by an arrow B.

### DETAILED DESCRIPTION

The embodiments described with reference to accompanying drawings are exemplary, and the embodiments of the present disclosure are described in detail below.

In the descriptions of the present disclosure, it should be understood that orientation or position relationships indicated by the terms such as "center", "longitudinal", "transverse", "length", "width", "thickness", "on", "below", "front", "back", "left", "right", "vertical", "horizontal", "top", "bottom", "inside", "outside", "clockwise", "counterclockwise", "axial direction", "radial direction", and "circumferential direction" are based on orientation or position relationships shown in the accompanying drawings, and are used only for ease and brevity of illustration and description, rather than indicating or implying that the mentioned apparatus or component needs to have a particular orientation or needs to be constructed and operated in a particular orientation.

In the descriptions of the disclosure, "a plurality of" means two or more.

A semiconductor power module 1 according to the embodiments of the disclosure is described below with reference to the accompanying drawings.

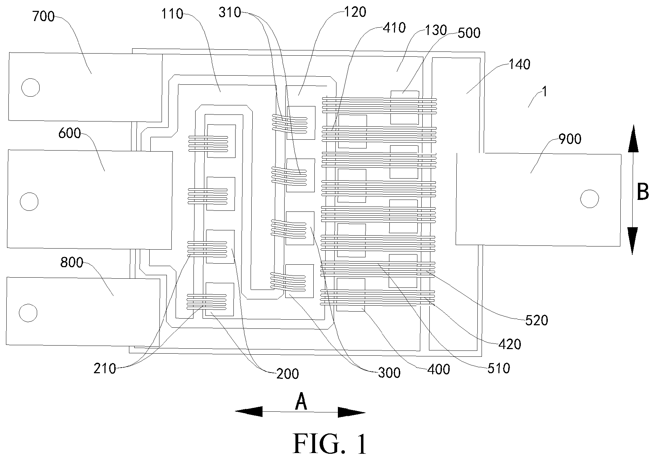

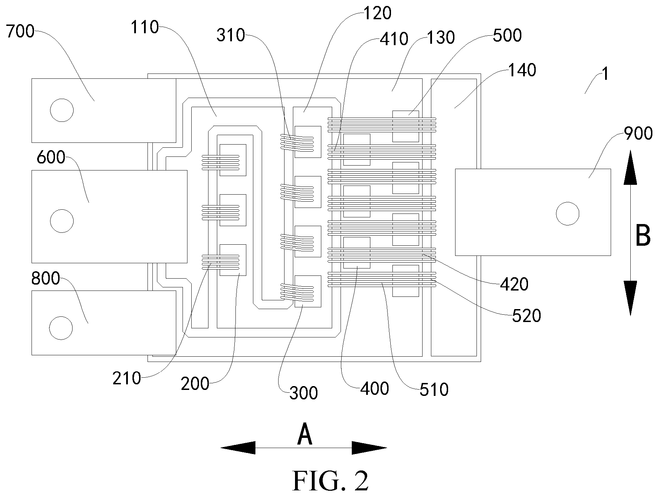

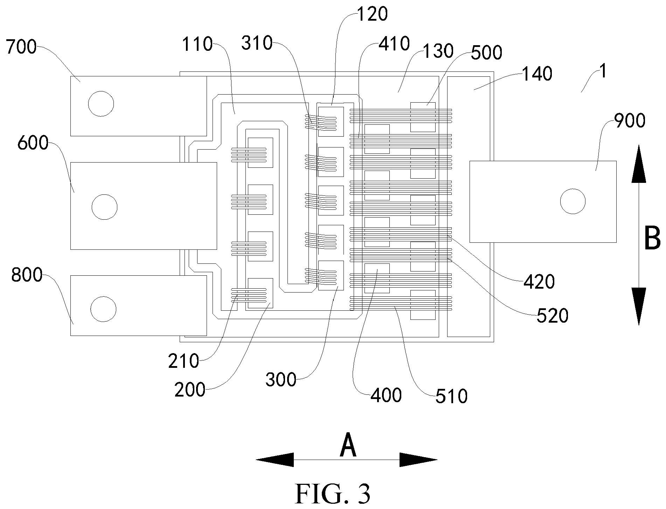

As shown in FIG. 1 to FIG. 10, the semiconductor power module 1 according to the embodiments of the present disclosure includes a substrate 100, at least one first power chip 200, and at least one second power chip 300.

The substrate 100 includes a first direction and a second direction orthogonal to each other. The substrate 100 includes a first conductive region 110 and a second conductive region 120 that are spaced apart on the substrate 100. The first conductive region 110 includes a first transverse section 111 and a second transverse section 112, and the second conductive region 120 includes a third transverse section 121 and a fourth transverse section 122. The first transverse section 111, the third transverse section 121, the second transverse section 112, and the fourth transverse section 122 are sequentially arranged in the first direction. The first conductive region 110 and the second conductive region 120 are configured to transmit DC signals. The first power chip 200 is respectively connected to the first transverse section 111 and the third transverse section 121, and the second power chip 300 is respectively connected to the second transverse section 112 and the fourth transverse section 122.

In other words, if the first direction is a length direction of the substrate 100, the second direction is a width direction of the substrate 100. Alternatively, if the first direction is the width direction of the substrate 100, the second direction is the length direction of the substrate 100. This may be set based on an actual situation, such as a shape of the substrate 100, and is not limited.

For example, the semiconductor power module 1 may be a silicon carbide metal oxide semiconductor field effect transistor (SiC MOSFET), or may be a device that cooperates with an IGBT (Insulated Gate Bipolar Transistor, insulated gate bipolar transistor) and an FRD (Fast recovery diode, fast recovery diode).

During actual application, the semiconductor power module 1 needs to be packaged, for example, in a plastic sealing manner, to be specific, a process in which a semi-finished product of the semiconductor power module 1 is injected and molded through plastic sealing, in other words, all structures in the semiconductor power module 1 are mounted in a frame and plastic sealed, to form a plastic-sealed body module. Alternatively, a potting sealing manner may be used, to be specific, a process in which a semi-finished product of the semiconductor power module 1 is potted and molded by using an insulating material such as silica gel, in other words, all structures in the semiconductor power module 1 are mounted in a frame, and the silica gel is filled into the frame, to form a potting-sealed module.

It should be noted that, the semiconductor power module 1 is a half-bridge power module, and may be used in a half-bridge circuit or a three-phase full-bridge circuit. For the plastic sealing manner, one single semiconductor power module 1 forms one plastic-sealed body, to be specific, one half-bridge circuit forms one plastic-sealed body; for the potting sealing manner, either one single semiconductor power module 1 may form one potting-sealed body, in other words, one half-bridge circuit forms one potting-sealed body, or three semiconductor power modules 1 may form one potting-sealed body, in other words, the three-phase full-bridge circuit formed by three half-bridge circuits forms one potting-sealed body.

According to the semiconductor power module 1 in this embodiment of the present disclosure, the first conductive region 110 and the second conductive region 120 are arranged on the substrate 100, to avoid a short circuit problem caused by an overlap between the first conductive region 110 and the second conductive region 120. In addition, the first conductive region 110 includes the first transverse section 111 and the second transverse section 112, the second conductive region 120 includes the third transverse section 121 and the fourth transverse section 122, and the first conductive region 110 and the second conductive region 120 are configured to transmit DC signals. The first transverse section 111 and the second transverse section 112 may be connected in series, and the third transverse section 121 and the fourth transverse section 122 may be connected in series.

In addition, the first transverse section 111, the third transverse section 121, the second transverse section 112, and the fourth transverse section 122 are sequentially arranged in the first direction, the first power chip 200 is respectively connected to the first transverse section 111 and the third transverse section 121, and the second power chip 300 is respectively connected to the second transverse section 112 and the fourth transverse section 122.

If the first power chip 200 is mounted on the first transverse section 111, the second power chip 300 is mounted on the second transverse section 112; if the first power chip 200 is mounted on the third transverse section 121, the second power chip 300 is mounted on the fourth transverse section 122. In other words, the first power chip 200 and the second power chip 300 are both mounted on the first conductive region 110 or the second conductive region 120, so that the first power chip 200 and the second power chip 300 form a series connection.

Because the first power chip 200 and the second power chip 300 are necessarily separated by one of the second transverse section 112 and the third transverse section 121, a distance between the first power chip 200 and the second power chip 300 is larger, so that heat accumulation of the first power chip 200 and the second power chip 300 can be avoided, and a heat dissipation effect of the semiconductor power module 1 can be improved.

For example, when the first power chip 200 and the second power chip 300 are respectively arranged on the first transverse section 111 and the second transverse section 112 of the first conductive region 110, while a connection area between the first power chip 200 and the second power chip 300 and the first conductive region 110 is ensured, a size of the first transverse section 111 and a size of the second transverse section 112 in the second direction do not need to be set to be excessively large, so that a size of the semiconductor power module 1 in the second direction can be reduced.

In the related art, only the first transverse section and the second transverse section that are sequentially arranged in the first direction are provided, both the first power chip and the second power chip need to be mounted on the first transverse section, both the first power chip and the second power chip are connected to the second transverse section, and the first power chip is at a greater distance from the second transverse section than the second power chip. Therefore, a connection structure between the second transverse section and the first power chip needs to be set to be long, and thus the connection structure between the second transverse section and the first power chip not only generates more heat, but also has a problem of a large stray inductance. However, in the semiconductor power module 1 in this embodiment of the present disclosure, the first power chip 200 is connected to the third transverse section 121, and the second power chip 300 is connected to the fourth transverse section 122. Therefore, a size of a connection structure between the second conductive region 120 and either of the first power chip 200 and the second power chip 300 is small, which not only generates less heat and facilitates heat dissipation, but also reduces a stray inductance and helps reduce a switching loss.

For example, when the first power chip 200 and the second power chip 300 are respectively arranged on the third transverse section 121 and the fourth transverse section 122 of the second conductive region 120, while a connection area between the first power chip 200 and the second power chip 300 and the second conductive region 120 is ensured, a size of the third transverse section 121 and a size of the fourth transverse section 122 in the second direction do not need to be set to be excessively large, so that a size of the semiconductor power module 1 in the second direction may be reduced.

In addition, in the related art, the first conductive region is provided with only the first transverse section, that is, the first conductive region is not provided with the second transverse section, and both the first power chip and the second power chip need to be connected to the first transverse section. Therefore, a connection structure between the first transverse section and the second power chip needs to be set to be long, and thus the connection structure between the first transverse section and the second power chip not only generates more heat, but also has a problem of a large stray inductance. However, in the semiconductor power module 1 in this embodiment of the present disclosure, the first power chip 200 is connected to the first transverse section 111, and the second power chip 300 is connected to the second transverse section 112. Therefore, a size of a connection structure between the first conductive region 110 and either of the first power chip 200 and the second power chip 300 is small, which not only generates less heat and facilitates heat dissipation, but also reduces a stray inductance and helps reduce a switching loss.

In summary, it can be learned that the semiconductor power module 1 in this embodiment of the present disclosure has a small stray inductance, a low temperature at a position of the power chip, and a very good heat dissipation effect, which is conducive to applying the semiconductor power module 1 to a circuit with a high switching speed.

In this way, the semiconductor power module 1 according to this embodiment of the present disclosure has advantages such as the small stray inductance and the good heat dissipation effect.

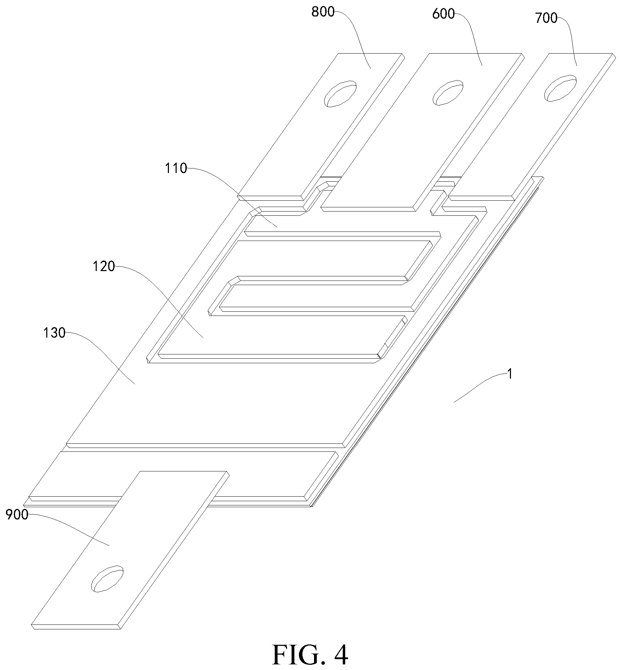

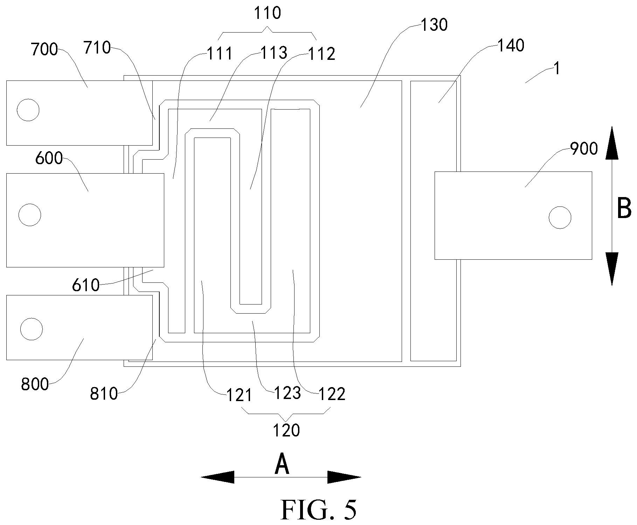

According to some specific embodiments of the present disclosure, in FIG. 4 and FIG. 5, the first conductive region 110 further includes a first vertical section 113. The first transverse section 111 and the second transverse section 112 both extend in the second direction, the first vertical section 113 extends in the first direction, and two ends of the first vertical section 113 are respectively connected to the first transverse section 111 and the second transverse section 112. The second conductive region 120 further includes a second vertical section 123. The third transverse section 121 and the fourth transverse section 122 both extend in the second direction, the second vertical section 123 extends in the first direction, and two ends of the second vertical section 123 are respectively connected to the third transverse section 121 and the fourth transverse section 122. The first vertical section 113 and the second vertical section 123 are respectively arranged adjacent to two opposite sides of the substrate 100 in the second direction.

In other words, the first conductive region 110 forms a "U"-shaped structure, and the second conductive region 120 forms a "U"-shaped structure. The first conductive region 110 is inserted into the second conductive region 120 from an opening of the second conductive region 120, and the second conductive region 120 is inserted into the first conductive region 110 from an opening of the first conductive region 110.

In this way, the first transverse section 111 and the second transverse section 112 are connected in series through the first vertical section 113, and the third transverse section 121 and the fourth transverse section 122 are connected in series through the second vertical section 123, so that the first power chip 200 and the second power chip 300 can be connected in series, and the first conductive region 110 and the second conductive region 120 occupy less space as a whole.

According to some specific embodiments of the present disclosure, in FIG. 4 and FIG. 5, one end of the first vertical section 113 is flush with a side of the first transverse section 111 that faces away from the second transverse section 112, and the other end of the first vertical section 113 is flush with a side of the second transverse section 112 that faces away from the first transverse section 111; one end of the second vertical section 123 is flush with a side of the third transverse section 121 that faces away from the fourth transverse section 122, and the other end of the second vertical section 123 is flush with a side of the fourth transverse section 122 that faces away from the third transverse section 121.

In other words, a sum of sizes of the first vertical section 113 and the fourth transverse section 122 in the first direction is equal to a sum of sizes of the second vertical section 123 and the first transverse section 111 in the first direction. In this way, the first conductive region 110 and the second conductive region 120 occupy less space as a whole in the first direction, and the first power chip 200 and the second power chip 300 are distributed more evenly in the first direction.

According to some specific embodiments of the present disclosure, in FIG. 4 and FIG. 5, a side of the first vertical section 113 that faces away from the second vertical section 123 is flush with an end of the fourth transverse section 122 away from the second vertical section 123, and a side of the second vertical section 123 that faces away from the first vertical section 113 is flush with a side of the first transverse section 111 away from the first vertical section 113.

In other words, a length of the first transverse section 111 may be the same as a length of the fourth transverse section 122, a length of the second transverse section 112 may be the same as a length of the third transverse section 121, a sum of sizes of the second transverse section 112 and the second vertical section 123 in the second direction is substantially equal to the length of the first transverse section 111, and a sum of sizes of the third transverse section 121 and the first vertical section 113 in the second direction is substantially equal to the length of the fourth transverse section 122.

In this way, the first conductive region 110 and the second conductive region 120 occupy less space as a whole in the second direction, thus helping to reduce a volume of the semiconductor power module 1.

According to some specific embodiments of the present disclosure, in FIG. 1 to FIG. 3, the first power chip 200 is mounted on the third transverse section 121, the first power chip 200 is connected to the first transverse section 111 through a first connection member 210, and the first connection member 210 is perpendicular to the first transverse section 111 and the third transverse section 121. The first connection member 210 may be an aluminum wire, a copper wire, a gold wire, a copper strip, an aluminum strip, a copper connecting piece, or the like, and the fourth connection member 420 may be an aluminum wire, a copper wire, a gold wire, a copper strip, an aluminum strip, a copper connecting piece, or the like.

In this way, the first connection member 210 and the first power chip 200 can implement a connection between the first conductive region 110 and the second conductive region 120. In addition, a length of the first connection member 210 is short, so that a parasitic inductance generated by the first connection member 210 in a circuit can be reduced, thereby reducing a switching loss, and an internal layout is more proper.

According to some specific embodiments of the present disclosure, in FIG. 1 to FIG. 3, the second power chip 300 is mounted on the fourth transverse section 122, the second power chip 300 is connected to the second transverse section 112 through the second connection member 310, and the second connection member 310 is perpendicular to the second transverse section 112 and the fourth transverse section 122. The second connection member 310 may be an aluminum wire, a copper wire, a gold wire, a copper strip, an aluminum strip, a copper connecting piece, or the like, and the fourth connection member 420 may be an aluminum wire, a copper wire, a gold wire, a copper strip, an aluminum strip, a copper connecting piece, or the like.

In this way, the second connection member 310 and the second power chip 300 can implement a connection between the first conductive region 110 and the second conductive region 120. In addition, a length of the second connection member 310 is short, so that a parasitic inductance generated by the second connection member 310 in a circuit can be reduced, thereby reducing a switching loss, and an internal layout is more proper. In addition, the first power chip 200 and the second power chip 300 are more dispersed, so that heat accumulation may be reduced, thereby improving a heat dissipation capability of the semiconductor power module 1.

According to some specific embodiments of the present disclosure, in FIG. 1 to FIG. 5, the semiconductor power module 1 further includes a third conductive region 130, a third power chip 400, and a fourth power chip 500.

The third conductive region 130 is arranged on the substrate 100 and is spaced apart from the first conductive region 110 and the second conductive region 120, and the third conductive region 130 is constructed in a closed loop shape arranged around the first conductive region 110 and the second conductive region 120.

Specifically, the third conductive region 130 includes a third vertical section 131, a fourth vertical section 132, a fifth transverse section 133, and a sixth transverse section 134; the third vertical section 131 and the fourth vertical section 132 extend in the first direction and are spaced apart in the second direction, the fifth transverse section 133 and the sixth transverse section 134 extend in the second direction and are spaced apart in the first direction; the third vertical section 131, the fifth transverse section 133, the fourth vertical section 132, and the sixth transverse section 134 are sequentially connected end to end; the first conductive region 110 and the second conductive region 120 are located between the third vertical section 131 and the fourth vertical section 132 in the second direction; the fifth transverse section 133 is located on a side of the fourth transverse section 122 that faces away from the third transverse section 121 in the first direction, and the third conductive region 130 is configured to transmit the DC signals, the third power chip 400 and the fourth power chip 500 are arranged on the fifth transverse section 133 and are both connected to the fourth transverse section 122.

In other words, the first power chip 200, the second power chip 300, the third power chip 400, and the fourth power chip 500 are respectively arranged in the first conductive region 110, the second conductive region 120, and the third conductive region 130, thereby avoiding a problem of heat increase caused by a compact power chip layout, and improving the heat dissipation capacity of the semiconductor power module 1.

In addition, the third power chip 400 and the fourth power chip 500 form a series connection on the third conductive region 130. Through this arrangement, inductances formed inside the semiconductor power module 1 may cancel each other when the semiconductor power module 1 works, so as to effectively reduce a parasitic inductance of the entire module, and optimize a structural layout inside the semiconductor power module 1, thereby improving integration of the semiconductor power module 1.

In addition, both the third power chip 400 and the fourth power chip 500 are connected to the second conductive region 120, so that the first conductive region 110, the second conductive region 120, and the third conductive region 130 are electrically connected to each other, and the semiconductor power module 1 can implement DC input/output.

According to some specific embodiments of the present disclosure, in FIG. 1 to FIG. 5, multiple third power chips 400 are spaced apart in the second direction, and the multiple third power chips 400 are arranged in a row in the second direction. Multiple fourth power chips 500 are spaced apart in the second direction, and the multiple fourth power chips 500 are arranged in a row in the second direction. The row in which the third power chip 400 is located and the row in which the fourth power chip 500 is located are spaced apart in the first direction. A sum of the quantities of the first power chips 200 and the second power chips 300 is the same as a sum of the quantities of the third power chips 400 and the fourth power chips 500.

For example, the third power chips 400 may be in a one-to-one correspondence with the first power chips 200, and the fourth power chips 500 may be in a one-to-one correspondence with the second power chips 300. In addition, a sum of the quantities of the first power chips 200 and the second power chips 300 may be set based on an output current of the semiconductor power module 1. For example, the sum of the quantities of the first power chips 200 and the second power chips 300 may be 6, 7, or 8. Certainly, the sum of the quantities of the first power chips 200 and the second power chips 300 may alternatively be another quantity, provided that usage requirements of different scenarios of the semiconductor power module 1 are met.

According to some specific embodiments of the present disclosure, in FIG. 1 to FIG. 3, the multiple third power chips 400 and the multiple fourth power chips 500 are arranged alternately in the second direction. In this way, wiring between the third power chip 400 and the fourth power chip 500 is less prone to interference, and an electrical connection is safer, so that space utilization of the semiconductor power module 1 is improved, and the third power chip 400 and the fourth power chip 500 are arranged more dispersedly, thereby further improving heat dissipation performance of the semiconductor power module 1.

According to some specific embodiments of the present disclosure, in FIG. 1 to FIG. 5, the semiconductor power module 1 further includes a fourth conductive region 140. The fourth conductive region 140 is arranged on the substrate 100 and is respectively spaced apart from the first conductive region 110, the second conductive region 120, and the third conductive region 130. The fourth conductive region 140 extends in the second direction and is located on a side of the fifth transverse section 133 that faces away from the fourth transverse section 122 in the first direction. Both the third power chip 400 and the fourth power chip 500 are connected to the fourth conductive region 140, and the fourth conductive region 140 is configured to transmit the AC signals.

In this way, the semiconductor power module 1 can implement a function of circuit conversion between a direct current and an alternating current, and the semiconductor power module 1 may be a half-bridge circuit.

According to some specific embodiments of the present disclosure, in FIG. 1 to FIG. 3, the third power chip 400 is connected to the fourth transverse section 122 through the third connection member 410, and the third connection member 410 is perpendicular to the fourth transverse section 122 and the fifth transverse section 133. The third power chip 400 is connected to the fourth conductive region 140 by the fourth connection member 420, and the fourth connection member 420 is perpendicular to the fifth transverse section 133 and the fourth conductive region 140. The third connection member 410 may be an aluminum wire, a copper wire, a gold wire, a copper strip, an aluminum strip, a copper connecting piece, or the like, and the fourth connection member 420 may be an aluminum wire, a copper wire, a gold wire, a copper strip, an aluminum strip, a copper connecting piece, or the like.

In other words, the third connection member 410 and the fourth connection member 420 are parallel, the fourth transverse section 122, the fifth transverse section 133, and the fourth conductive region 140 are parallel, and the third connection member 410 and the fourth connection member 420 are respectively perpendicular to the fourth transverse section 122, the fifth transverse section 133, and the fourth conductive region 140.

In this way, lengths of the third connection member 410 and the fourth connection member 420 are smaller, so that a line arrangement can be simplified, and inductances generated by the third connection member 410 and the fourth connection member 420 can be reduced, thereby reducing a switching loss and heat generation, and improving heat dissipation performance.

According to some specific embodiments of the present disclosure, in FIG. 1 to FIG. 3, the third connection member 410 and the fourth connection member 420 are configured as an integrated member extending in the first direction. In this way, arrangement difficulty can be reduced, production efficiency can be improved, less inductance is generated, and functional performance of the semiconductor power module 1 is better.

According to some specific embodiments of the present disclosure, in FIG. 1 to FIG. 3, the fourth connection member 420 and the fourth power chip 500 are spaced apart in the second direction. In this way, contact between the fourth connection member 420 and the fourth power chip 500 can be avoided, thus reliability of the electrical connection can be prevented from being affected, thereby ensuring effectiveness of the semiconductor power module 1.

According to some specific embodiments of the present disclosure, in FIG. 1 to FIG. 3, the fourth power chip 500 is connected to the fourth transverse section 122 through the fifth connection member 510, and the fifth connection member 510 is perpendicular to the fourth transverse section 122 and the fifth transverse section 133. The fourth power chip 500 is connected to the fourth conductive region 140 through the sixth connection member 520, and the sixth connection member 520 is perpendicular to the fifth transverse section 133 and the fourth conductive region 140. The fifth connection member 510 may be an aluminum wire, a copper wire, a gold wire, a copper strip, an aluminum strip, a copper connecting piece, or the like, and the sixth connection member 520 may be an aluminum wire, a copper wire, a gold wire, a copper strip, an aluminum strip, a copper connecting piece, or the like.

In other words, the fifth connection member 510 and the sixth connection member 520 are parallel, the fourth transverse section 122, the fifth transverse section 133, and the fourth conductive region 140 are parallel, and the fifth connection member 510 and the sixth connection member 520 are respectively perpendicular to the fourth transverse section 122, the fifth transverse section 133, and the fourth conductive region 140.

In this way, lengths of the fifth connection member 510 and the sixth connection member 520 are smaller, so that a line arrangement can be simplified, and inductances generated by the fifth connection member 510 and the sixth connection member 520 can be reduced, thereby reducing a switching loss and heat generation, and improving heat dissipation performance.

According to some specific embodiments of the present disclosure, in FIG. 1 to FIG. 3, the fifth connection member 510 and the sixth connection member 520 are configured as an integrated member extending in the first direction. In this way, arrangement difficulty can be reduced, production efficiency can be improved, less inductance is generated, and functional performance of the semiconductor power module 1 is better.

According to some specific embodiments of the present disclosure, in FIG. 1 to FIG. 3, the fifth connection member 510 and the third power chip 400 are spaced apart in the second direction. In this way, contact between the fifth connection member 510 and the third power chip 400 can be avoided, thus reliability of the electrical connection can be prevented from being affected, thereby ensuring effectiveness of the semiconductor power module 1.

According to some specific embodiments of the present disclosure, in FIG. 4 to FIG. 7, the semiconductor power module 1 further includes a first DC transmission terminal 600, a second DC transmission terminal 700, a third DC transmission terminal 800, and a AC transmission terminal 900.

The first DC transmission terminal 600 is connected to the first transverse section 111 and extends beyond the edge of the substrate 100, the second DC transmission terminal 700 is connected to an end of the third vertical section 131 away from the fifth transverse section 133 and extends beyond the edge of the substrate 100, the third DC transmission terminal 800 is connected to an end of the fourth vertical section 132 away from the fifth transverse section 133 and extends beyond the edge of the substrate 100, and the AC transmission terminal 900 is connected to the fourth conductive region 140 and extends beyond the edge of the substrate 100.

For example, the first DC transmission terminal 600, the second DC transmission terminal 700, and the third DC transmission terminal 800 are located on one of two opposite sides of the substrate 100, and the AC transmission terminal 900 is located on the other of the two opposite sides of the substrate 100. In this way, a connection between the alternating current and the direct current does not interfere with each other, and electrical connection safety is improved. In addition, a conductive circuit between the second DC transmission terminal 700 and the AC transmission terminal 900 may form a first bridge arm, and a conductive circuit between the third DC transmission terminal 800 and the AC transmission terminal 900 may form a second bridge arm. Inductances formed between a circuit formed by the first bridge arm and a circuit formed by the second bridge arm cancel each other out, thereby reducing a parasitic inductance of the entire semiconductor power module 1, improving a filtering capability of the semiconductor power module 1, and reducing a switching loss.

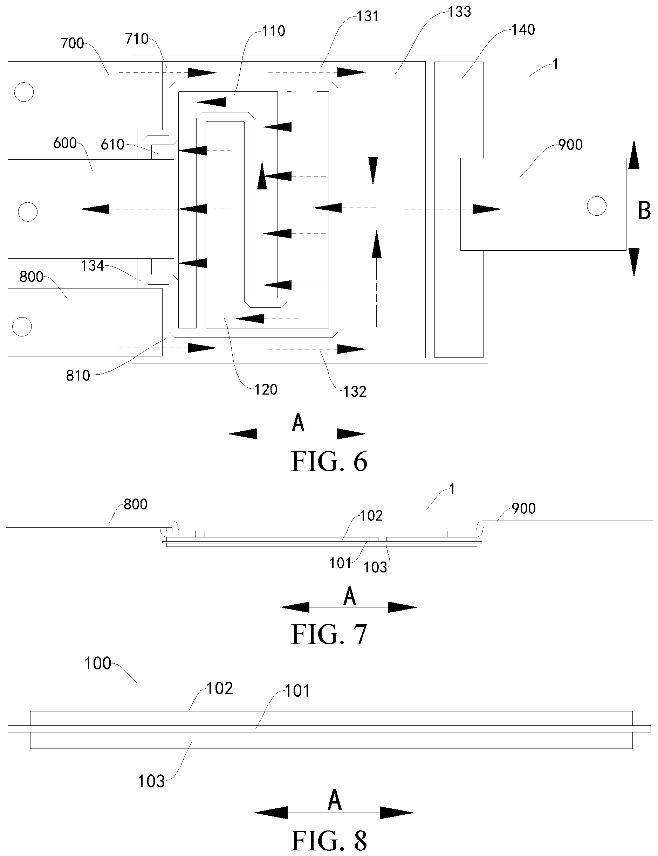

In FIG. 6, dashed arrows show a current flow direction in an optional working state of the semiconductor power module 1. It may be understood that, the semiconductor power module 1 may alternatively have another current flow direction in the working state, for example, a current flow direction on each conductive region itself. Certainly, the semiconductor power module 1 may alternatively have a current flow direction of another manner in another working state.

According to some specific embodiments of the present disclosure, in FIG. 5, the first high-voltage connection part 710 is arranged at an end of the third vertical section 131 away from the fifth transverse section 133. A size of the first high-voltage connection part 710 in the second direction is greater than a width of the third vertical section 131 and greater than a width of the second DC transmission terminal 700. The second DC transmission terminal 700 is connected to the first high-voltage connection part 710. A width of the third vertical section 131 is less than a width of the second DC transmission terminal 700, so that a size of the semiconductor power module 1 in the second direction is reduced, thereby facilitating miniaturization of the semiconductor power module 1.

By arranging the first high-voltage connection part 710, the third vertical section 131 can be connected to the second DC transmission terminal 700, and in addition, the second DC transmission terminal 700 does not extend beyond the first high-voltage connection part 710 in the second direction, so that a contact area between the second DC transmission terminal 700 and the third vertical section 131 is improved, thereby ensuring reliability of an electrical connection between the second DC transmission terminal 700 and the third vertical section 131.

In addition, the second high-voltage connection part 810 is arranged at an end of the fourth vertical section 132 away from the fifth transverse section 133. A size of the second high-voltage connection part 810 in the second direction is greater than a width of the fourth vertical section 132 and greater than a width of the third DC transmission terminal 800, and the third DC transmission terminal 800 is connected to the second high-voltage connection part 810. A width of the fourth vertical section 132 is less than a width of the third DC transmission terminal 800, so that a size of the semiconductor power module 1 in the second direction is reduced, thereby facilitating miniaturization of the semiconductor power module 1.

By arranging the second high-voltage connection part 810, the fourth vertical section 132 can be connected to the third DC transmission terminal 800, and in addition, the third DC transmission terminal 800 does not extend beyond the second high-voltage connection part 810 in the second direction, so that a contact area between the third DC transmission terminal 800 and the fourth vertical section 132 is improved, thereby ensuring reliability of an electrical connection between the third DC transmission terminal 800 and the fourth vertical section 132.

According to some embodiments of the present disclosure, in FIG. 5, a low-voltage connection part 610 is arranged on a side of the first transverse section 111 that faces away from the second transverse section 112. A length of the low-voltage connection part 610 is less than a length of the first transverse section 111 and greater than a width of the first DC transmission terminal 600. The first DC transmission terminal 600 is connected to the low-voltage connection part 610.

The first high-voltage connection part 710 and the second high-voltage connection part 810 are located on two opposite sides of the low-voltage connection part 610 in the second direction. Through making the length of the low-voltage connection part 610 less than the length of the first transverse section 111, the low-voltage connection part 610 can avoid the first high-voltage connection part 710 and the second high-voltage connection part 810. In addition, while a reliable connection between the low-voltage connection part 610 and the low-voltage connection part 610 is ensured, a size of the semiconductor power module 1 in the second direction is prevented from increasing, thereby facilitating miniaturization of the semiconductor power module 1.

By arranging the low-voltage connection part 610, the first transverse section 111 can be connected to the low-voltage connection part 610, and in addition, the low-voltage connection part 610 does not extend beyond the first transverse section 111 in the second direction, thereby ensuring reliability of an electrical connection between the first DC transmission terminal 600 and the first transverse section 111.

According to some specific embodiments of this the present disclosure, in FIG. 5, a width of the second DC transmission terminal 700 is the same as a width of the third DC transmission terminal 800 and is less than a width of the first DC transmission terminal 600. Because the second DC transmission terminal 700 and the third DC transmission terminal 800 are both connected to the third conductive region 130, the width of the first DC transmission terminal 600 may be substantially equal to a sum of the width of the second DC transmission terminal 700 and the width of the third DC transmission terminal 800, to ensure that a direct current input impedance is substantially the same as a direct current output impedance, thereby reducing heat generation of the semiconductor power module 1.

According to some specific embodiments of the present disclosure, in FIG. 7 and FIG. 8, the substrate 100 includes an insulation layer 101, a circuit layer 102, and a heat dissipation layer 103. The circuit layer 102 is connected to a side of the insulation layer 101 in a thickness direction, the first conductive region 110 and the second conductive region 120 are formed on the circuit layer 102, and the heat dissipation layer 103 is connected to the other side of the insulation layer 101 in the thickness direction.

The insulation layer 101 may be made of ceramic, for example, made of aluminum oxide (Al2O3), aluminum nitride (AlN), and silicon nitride (Si3N4). In this way, the insulation layer 101 has a good heat conduction effect, a strong insulation capability, and a stable chemical property, which may not only isolate a connection between the conductive layer and the heat dissipation layer 103, but also provide a heat dissipation channel for the semiconductor power module 1.

The circuit layer 102 may be made of a copper material, and the copper is etched into the first conductive region 110, the second conductive region 120, the third conductive region 130, and the fourth conductive region 140. The heat dissipation layer 103 may be made of a copper material, and the first DC transmission terminal 600, the second DC transmission terminal 700, the third DC transmission terminal 800, and the AC transmission terminal 900 may all be made of copper materials. In this way, the circuit layer 102, the heat dissipation layer 103, the first DC transmission terminal 600, the second DC transmission terminal 700, the third DC transmission terminal 800, and the AC transmission terminal 900 all have good conductivity performance and heat dissipation performance, and can be effectively connected to an external device.

According to some specific embodiments of the present disclosure, in FIG. 1, FIG. 2, FIG. 3, and FIG. 9, the semiconductor power module 1 further includes an insulation cover 1100. The insulation cover 1100 is mounted on the substrate 100 and covers the first conductive region 110, the second conductive region 120, the first power chip 200, and the second power chip 300. The insulation cover 1100 may insulate and protect a device, thereby improving safety of an electrical connection of the semiconductor power module 1.

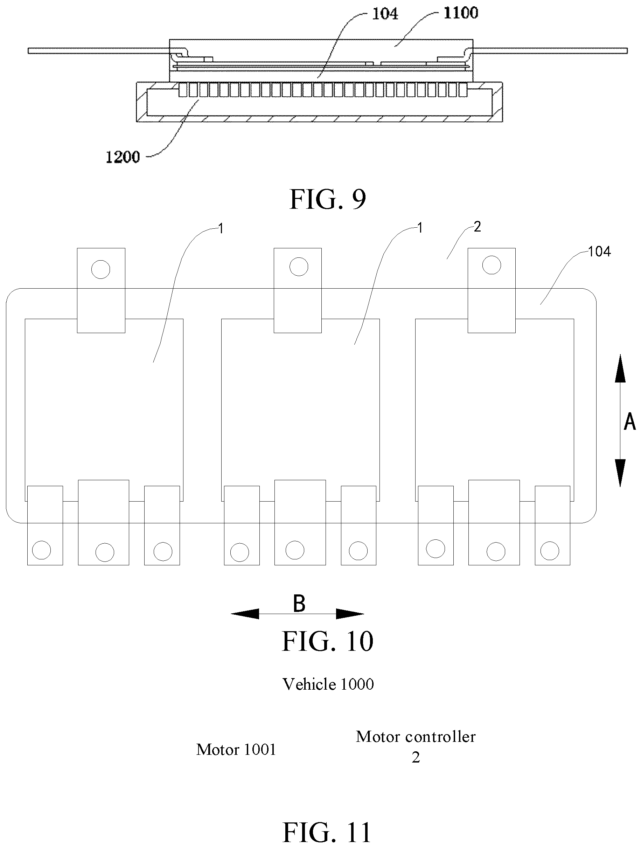

A motor controller 2 according to an embodiment of the present disclosure is described below with reference to the accompanying drawings. In FIG. 9 and FIG. 10, the motor controller 2 includes a heat dissipation bottom plate 104, a coolant channel 1200, and the semiconductor power module 1 according to the foregoing embodiments of the present disclosure. The heat dissipation bottom plate 104 is mounted in the coolant channel 1200, and the semiconductor power module 1 is arranged on the heat dissipation bottom plate 104.

For example, there are multiple semiconductor power modules 1 and are arranged on the heat dissipation bottom plate 104 in the second direction, and the multiple semiconductor power modules 1 may be arranged in parallel. A bottom of each semiconductor power module 1 is welded to the heat dissipation bottom plate 104. The coolant channel 1200 may be an open-groove water channel, and the heat dissipation bottom plate 104 is mounted on the open groove of the coolant channel 1200, so that a heat dissipation function for the semiconductor power module 1 is implemented. This design process is simple, easy to implement, and convenient to operate.

In this embodiment, the semiconductor power module 1 provided based on the foregoing embodiments has a uniform structural layout and a good heat dissipation effect, and the motor controller 2 can be used in various coolant channel applications, such as a series coolant channel or a parallel coolant channel, so that application flexibility of the motor controller 2 is improved, and a stray inductance in a loop during application is reduced.

By using the semiconductor power module 1 according to the foregoing embodiment of the present disclosure, the motor controller 2 according to the embodiment of the present disclosure has advantages such as a small stray inductance and a good heat dissipation effect.

A vehicle 1000 according to an embodiment of the present disclosure is described below with reference to FIG. 11. The vehicle 1000 includes a motor 1001 and the motor controller 2 according to the foregoing embodiment of the present disclosure. The motor controller 2 is connected to the motor 1001.

By using the motor controller 2 according to the embodiment of the present disclosure, the vehicle according to the embodiment of the present disclosure has advantages such as a small stray inductance and a good heat dissipation effect.

Other configurations and operations of the semiconductor power module 1, the motor controller 2, and the vehicle according to the embodiments of the present disclosure are known to a person of ordinary skill in the art and will not be described in detail herein.

In the description of this specification, the description of the reference terms such as "an embodiment", "some embodiments", "exemplary embodiments", "example", "specific example", or "some examples" means that the specific features, structures, materials or characteristics described with reference to the embodiment or example are included in at least one embodiment or example of the present disclosure. In this specification, schematic descriptions of the foregoing terms are not necessarily directed at a same embodiment or example.

Although the embodiments of the present disclosure have been shown and described, a person of ordinary skill in the art should understand that various changes, modifications, replacements and variations may be made to the embodiments without departing from the principles and spirit of the present disclosure, and the scope of the present disclosure is as defined by the appended claims and their equivalents.

## Claims

1. A semiconductor power module (1), comprising:
a substrate (100), the substrate (100) comprising a first direction and a second direction orthogonal to each other;
a first conductive region (110), the first conductive region (110) comprising a first transverse section (111) and a second transverse section (112);
a second conductive region (120), the second conductive region (120) and the first conductive region (110) being spaced apart on the substrate (100); the second conductive region (120) comprising a third transverse section (121) and a fourth transverse section (122); and the first transverse section (111), the third transverse section (121), the second transverse section (112), and the fourth transverse section (122) being sequentially arranged in the first direction, wherein the first conductive region (110) and the second conductive region (120) are configured to transmit DC signals;
at least one first power chip (200), the first power chip (200) being respectively connected to the first transverse section (111) and the third transverse section (121); and
at least one second power chip (300), the second power chip (300) being respectively connected to the second transverse section (112) and the fourth transverse section (122).

2. The semiconductor power module (1) according to claim 1, wherein the first conductive region (110) further comprises a first vertical section (113), the first transverse section (111) and the second transverse section (112) both extend in the second direction, the first vertical section (113) extends in the first direction, and two ends of the first vertical section (113) are respectively connected to the first transverse section (111) and the second transverse section (112);
the second conductive region (120) further comprises a second vertical section (123), the third transverse section (121) and the fourth transverse section (122) both extend in the second direction, the second vertical section (123) extends in the first direction, and two ends of the second vertical section (123) are respectively connected to the third transverse section (121) and the fourth transverse section (122); and
the first vertical section (113) and the second vertical section (123) are respectively arranged adjacent to two opposite sides of the substrate (100) in the second direction.

3. The semiconductor power module (1) according to claim 2, wherein an end of the first vertical section (113) is flush with a side of the first transverse section (111) that faces away from the second transverse section (112), and another end of the first vertical section (113) is flush with a side of the second transverse section (112) that faces away from the first transverse section (111); and
an end of the second vertical section (123) is flush with a side of the third transverse section (121) that faces away from the fourth transverse section (122), and another end of the second vertical section (123) is flush with a side of the fourth transverse section (122) that faces away from the third transverse section (121).

4. The semiconductor power module (1) according to claim 2 or 3, wherein a side of the first vertical section (113) that faces away from the second vertical section (123) is flush with an end of the fourth transverse section (122) away from the second vertical section (123); and
a side of the second vertical section (123) that faces away from the first vertical section (113) is flush with a side of the first transverse section (111) away from the first vertical section (113).

5. The semiconductor power module (1) according to any one of claims 1 to 4, wherein the first power chip (200) is mounted on the third transverse section (121), and the first power chip (200) is connected to the first transverse section (111) through a first connection member (210).

6. The semiconductor power module (1) according to any one of claims 1 to 5, wherein the second power chip (300) is mounted on the fourth transverse section (122), and the second power chip (300) is connected to the second transverse section (112) through a second connection member (310).

7. The semiconductor power module (1) according to any one of claims 1 to 6, further comprising:
a third conductive region (130), the third conductive region (130) being arranged on the substrate (100) and spaced apart from the first conductive region (110) and the second conductive region (120), and the third conductive region (130) being constructed in a closed loop shape arranged around the first conductive region (110) and the second conductive region (120).

8. The semiconductor power module (1) according to claim 7, wherein
the third conductive region (130) comprises:
a third vertical section (131);
a fourth vertical section (132), the fourth vertical section (132) and the third vertical section (131) extending in the first direction and being spaced apart from each other in the second direction;
a fifth transverse section (133); and
a sixth transverse section (134), the sixth transverse section (134) and the fifth transverse section (133) extending in the second direction and being spaced apart in the first direction; the third vertical section (131), the fifth transverse section (133), the fourth vertical section (132), and the sixth transverse section (134) being sequentially connected end to end; the first conductive region (110) and the second conductive region (120) being located between the third vertical section (131) and the fourth vertical section (132) in the second direction; and the fifth transverse section (133) being located on the side of the fourth transverse section (122) that faces away from the third transverse section (121) in the first direction, wherein the third conductive region (130) is configured to transmit DC signals; and
the semiconductor power module further comprises:
at least one third power chip (400), the third power chip (400) being arranged on the fifth transverse section (133), and the third power chip (400) being connected to the fourth transverse section (122); and
at least one fourth power chip (500), the fourth power chip (500) being arranged on the fifth transverse section (133), and the fourth power chip (500) being connected to the fourth transverse section (122).

9. The semiconductor power module (1) according to claim 8, wherein a plurality of third power chips (400) are comprised, the plurality of third power chips (400) are spaced apart in the second direction, and the plurality of third power chips (400) are arranged in a row in the second direction; and
a plurality of fourth power chips (500) are comprised, the plurality of fourth power chips (500) are spaced apart in the second direction, and the plurality of fourth power chips (500) are arranged in a row in the second direction;
the row in which the third power chips (400) are located and the row in which the fourth power chips (500) are located are spaced apart in the first direction; and
a sum of a quantity of first power chips (200) and a quantity of second power chips (300) is the same as a sum of a quantity of the third power chips (400) and a quantity of the fourth power chips (500).

10. The semiconductor power module (1) according to claim 9, wherein the plurality of third power chips (400) and the plurality of fourth power chips (500) are alternately arranged in the second direction.

11. The semiconductor power module (1) according to any one of claims 8 to 10, comprising:
a fourth conductive region (140), the fourth conductive region (140) being arranged on the substrate (100) and spaced apart from the first conductive region (110), the second conductive region (120), and the third conductive region (130); the fourth conductive region (140) extending in the second direction and being located on a side of the fifth transverse section (133) that faces away from the fourth transverse section (122) in the first direction, and the third power chip (400) and the fourth power chip (500) being both connected to the fourth conductive region (140),
wherein the fourth conductive region (140) is configured to transmit AC signals.

12. The semiconductor power module (1) according to claim 11, wherein the third power chip (400) is connected to the fourth transverse section (122) through a third connection member (410); and
the third power chip (400) is connected to the fourth conductive region (140) through a fourth connection member (420).

13. The semiconductor power module (1) according to claim 12, wherein the third connection member (410) and the fourth connection member (420) are constructed as an integrated member extending in the first direction.

14. The semiconductor power module (1) according to claim 12 or 13, wherein the fourth connection member (420) and the fourth power chip (500) are spaced apart in the second direction.

15. The semiconductor power module (1) according to any one of claims 11 to 14, wherein the fourth power chip (500) is connected to the fourth transverse section through a fifth connection member (510); and
the fourth power chip (500) is connected to the fourth conductive region (140) through a sixth connection member (520).

16. The semiconductor power module (1) according to claim 15, wherein the fifth connection member (510) and the sixth connection member (520) are constructed as an integrated member extending in the first direction.

17. The semiconductor power module (1) according to claim 15 or 16, wherein the fifth connection member (510) and the third power chip (400) are spaced apart in the second direction.

18. The semiconductor power module (1) according to any one of claims 11 to 17, comprising:
a first DC transmission terminal (600), the first DC transmission terminal (600) being connected to the first transverse section (111) and extending beyond an edge of the substrate (100);
a second DC transmission terminal (700), the second DC transmission terminal (700) being connected to an end of the third vertical section (131) away from the fifth transverse section (133) and extending beyond the edge of the substrate (100);
a third DC transmission terminal (800), the third DC transmission terminal (800) being connected to an end of the fourth vertical section (132) away from the fifth transverse section (133) and extending beyond the edge of the substrate (100); and
an AC transmission terminal (900), the AC transmission terminal (900) being connected to the fourth conductive region (140) and extending beyond the edge of the substrate (100).

19. The semiconductor power module (1) according to claim 18, further comprising:
a low-voltage connection part (610), the low-voltage connection part (610) being arranged on the side of the first transverse section (111) that faces away from the second transverse section (112), a length of the low-voltage connection part (610) being less than a length of the first transverse section (111) and greater than a width of the first DC transmission terminal (600), and the first DC transmission terminal (600) being connected to the low-voltage connection part (610).

20. The semiconductor power module (1) according to claim 18 or 19, further comprising:
a first high-voltage connection part (710), the first high-voltage connection part (710) being arranged on the end of the third vertical section (131) away from the fifth transverse section (133), a size of the first high-voltage connection part (710) in the second direction being greater than a width of the third vertical section (131) and greater than a width of the second DC transmission terminal (700), and the second DC transmission terminal (700) being connected to the first high-voltage connection part (710); and
a second high-voltage connection part (810), the second high-voltage connection part (810) being arranged on the end of the fourth vertical section (132) away from the fifth transverse section (133), a size of the second high-voltage connection part (810) in the second direction being greater than a width of the fourth vertical section (132) and greater than a width of the third DC transmission terminal (800), and the third DC transmission terminal (800) being connected to the second high-voltage connection part (810).

21. The semiconductor power module (1) according to any one of claims 1 to 20, wherein the substrate (100) comprises:
an insulation layer (101);
a circuit layer (102), the circuit layer (102) being connected to a side of the insulation layer (101) in a thickness direction, and the first conductive region (110) and the second conductive region (120) being formed on the circuit layer (102); and
a heat dissipation layer (103), the heat dissipation layer (103) being connected to another side of the insulation layer (101) in the thickness direction.

22. The semiconductor power module (1) according to any one of claims 1 to 21, further comprising:
an insulation cover (1100), the insulation cover (1100) being mounted on the substrate (100) and covering the first conductive region (110), the second conductive region (120), the first power chip (200), and the second power chip (300).

23. A motor controller (2), comprising:
a heat dissipation bottom plate (104);
a coolant channel (1200), the heat dissipation bottom plate (104) being mounted in the coolant channel (1200); and
the semiconductor power module (1) according to any one of claims 1 to 22, the semiconductor power module (1) being arranged on the heat dissipation bottom plate (104).

24. The motor controller (2) according to claim 23, wherein a plurality of semiconductor power modules (1) are arranged on the heat dissipation bottom plate (104) in the second direction.

25. A vehicle (1000), comprising:
a motor (1001); and
the motor controller (2) according to claim 23 or 24, the motor controller (2) being connected to the motor (1001).
